# EUROPEAN PATENT SPECIFICATION

(11) **EP 0 890 187 B1**
(45) Date of publication and mention of the grant of the patent: **02.11.2006**
(21) Application number: 97915824.3
(22) Date of filing: 26.03.1997
(51) Int. Cl.: H01L 21/20, H01L 23/48

(54) **A METHOD FOR PRODUCING A SEMICONDUCTOR DEVICE BY THE USE OF AN IMPLANTING STEP**
VERFAHREN ZUR HERSTELLUNG EINES HALBLEITERBAUELEMENTES MIT EINEM IMPLANTIERUNGSSCHRITT
PROCEDE DE FABRICATION D'UN COMPOSANT A SEMI-CONDUCTEUR AU MOYEN D'UNE ETAPE D'IMPLANTATION

(30) Priority: 27.03.1996 SE 9601175
(43) Date of publication of application: 13.01.1999
(73) Proprietor: CREE, INC., Durham, NC 27703 (US)
(72) Inventor: SCHÖNER, Adolf, S-164 44 Kista (SE); ROTTNER, Kurt, S-164 43 Kista (SE)
(74) Representative: Olsson, Jan
(86) International application number: PCT/SE1997/000534
(87) International publication number: WO 1997/036319

(56) References cited:
- US-A- 4 775 882
- US-A- 5 291 058

## Description

### TECHNICAL FIELD OF THE INVENTION AND PRIOR ART

The present invention relates to a method for producing a semiconductor device having a SiC layer with a pn-junction therein, comprising a step a) of implanting an impurity dopant of a first conductivity type, one of a) n and b) p, into said SiC layer being doped according to a second opposite conductivity type for forming a first type doped surface layer surrounded, except for the top surface thereof, by second conductivity type doped regions of said semiconductor layer for forming a pn-junction at the interface thereto.

Such an ion implantation technique may be used for production of all types of semiconductor devices, and all semiconductor devices having a pn-junction created by such an implantation step are comprised inspite of the presence of several further pn-junctions. Examples of such devices are different types of diodes, transistors and thyristors, and this technique allows the formation of a planar structure which is favourable in several respects, particularly for solving the passivation problem. A very high, if not the highest, electric field occurs in reverse bias of a semiconductor device, having a blocking pn-junction, in the insulator very close to the pn-junction. In mesa structured devices the intersection of the pn-junction with the interface to the passivating insulator is at the lateral mesa walls where the surface conditions are hard to control. In addition the crystallographic orientation of the interface changes gradually around the mesa. These problems do not occur in planar structures obtainable by ion implantation. However, one technological difficulty is the requirement of highly doped contact layers necessary for the formation of low resistance ohmic contacts. With ion implantation the maximum doping concentration is limited by the amorphization of the material. Thus, the maximum doping concentration obtainable by the ion implantation is considerably lower than in said mesa structures, so that the passivation problem is solved, but this has been made at the cost of a degraded contact layer of the device so created.

This overall problem is particularly pronounced in using a method defined in the introduction for the production of semiconductor devices having SiC as said semiconductor layer, since such production techniques are more developed for some other material, especially for Si, so that the present invention is particularly occupied with solving this problem for the production of semiconductor devices of SiC, where the advantages of such a planar structure is considerably greater than for especially Si due to the inherent characteristics of SiC with the ability to hold up to five times higher voltages in the blocking state of a semiconductor device made of SiC than one made of Si, which make such devices well suitable for high power applications. However, it is only possible to benefit from this excellent property of SiC to a small extent would a mesa structure pn-junction be used.

### SUMMARY OF THE INVENTION

The object of the present invention is to provide a method of the type mentioned in the introduction through which the overall problem discussed above may be solved.

This object is in accordance with the invention obtained by providing such a method with a step b) following upon step a) and in which a highly doped additional semiconductor layer of said first conductivity type is epitaxially grown on top of said surface layer for forming a contact layer allowing a low resistance ohmic contact to be established to the device so created.

By combining this so called re-growth step with the implantation step it will be possible to take advantages of the preferred characteristics of each of said technique, so that it will be possible to locate the intersection of the pn-junction with the interface to the insulator where the surface conditions are easy to control and by the step of epitaxial growth a contact layer allowing a low resistance ohmic contact to be established to the device may also be obtained. Such an epitaxially grown contact layer can be doped much higher than an implanted layer (normally more than one order of magnitude).

According to a preferred embodiment of the invention said method is characterized by one of a) in step b) said additional semiconductor layer is grown on top of said surface layer with lateral walls thereof being surrounded by the surface contour of said surface layer with a distance therebetween for separating the pn-junction from said contact layer, and b) in step b) said additional semiconductor layer is grown on top of said SiC layer and after that structured so that lateral walls thereof are surrounded by the surface contour of said surface layer with a distance therebetween for separating the pn-junction from said contact layer. In this way the preferred device structure with a separation of said pn-junction from the contact layer may be obtained. Thanks to this characteristic it will be possible to keep the high electric field obtained at the surface across said pn-junction in the reverse bias state of a semiconductor device so created away from said lateral walls of the contact layer for preventing problems with leakage currents, breakdowns and destruction of the device. In addition it would be possible to cover the pn-junction where it reaches the surface with an insulating passivation layer to prevent the semiconductor device from breaking down at the surface near the pn-junction.

According to another preferred embodiment of the invention said contact layer is given a lower surface contour corresponding to a coverage of the main part of said surface layer. This will make it possible to obtain large currents in the on-state of the device and a substantially uniform distribution of the electrical field lines over said pn-junction.

According to another preferred embodiment of the invention said distance separating said pn-junction from said contact layer is selected so as to prevent the depletion region of said junction under the intended reverse bias of the semiconductor device so created from reaching said contact layer. The advantage of such a design is as already mentioned that no high electric field will occur at said lateral walls of the contact layer.

According to a further preferred embodiment of the invention said contact layer is in step b) epitaxially grown with a doping concentration above 10¹⁹ cm⁻³, and according to a still more preferred embodiment of the invention above 10²⁰ cm⁻³, so that in this way by combining the epitaxial growth with the implantation technique a considerably higher doping concentration of the layer intended to serve as contact layer may be obtained than should no such step be utilised.

Such a method is especially well suited for the production of a semiconductor device having such a SiC layer, since it will then be possible to have a low resistance ohmic contact thereto and still fully benefit from the property of SiC to withstand high voltages in the blocking state of such a device by said planar structure obtained for said pn-junction.

According to another preferred embodiment of the invention said contact layer is in step b) grown by epitaxy of SiC and impurity dopants. This is of course preferred since it makes it possible to grow a contact layer of a good order on said surface layer.

According to another preferred embodiment of the invention said first conductivity type dopants implanted in step a) and grown into the additional semiconductor layer in step b) are of p-type. The implantation technique is, for the SiC layer, furthest developed for acceptors, but it is emphasised that the invention is not in any way restricted to the use of p-type dopants as said first conductivity type dopants, and in fact this technique has also been successfully used for donors.

According to another preferred embodiment of the invention Al is used as impurity dopant in said additional semiconductor layer, and said contact layer is in step b) grown by epitaxy of SiC and this impurity dopant. It has turned out that very high doping concentrations with a good order of the layer grown may be obtained by using Al as impurity dopant for the epitaxial growth of SiC.

According to another preferred embodiment of the invention said additional semiconductor layer is grown by Chemical Vapour Deposition, which is a preferred and the most common technique for epitaxial growth of semiconductor layers.

According to another preferred embodiment of the invention being a development of that previously mentioned, said additional semiconductor layer is grown by heating said SiC layer at such a high temperature that the impurity dopants implanted in step a) are made electrically active and implantation damages are reduced. Thus, no separate annealing step is necessary, but the impurity dopants implanted in step a) will automatically become electrically active during the Chemical Vapour Deposition growth of said contact layer.

According to another preferred embodiment of the invention, in which said SiC layer and said additional semiconductor layer are made of SiC, said temperature is higher than 1500°C, which will ensure a good annealing of said surface layer created by the implantation step.

Further preferred features and advantages of the invention will appear from the following description and the other dependent claims.

### BRIEF DESCRIPTION OF THE DRAWINGS

With reference to the appended drawings, below follows a specific description of a preferred embodiment of the invention cited as an example.

In the drawings:

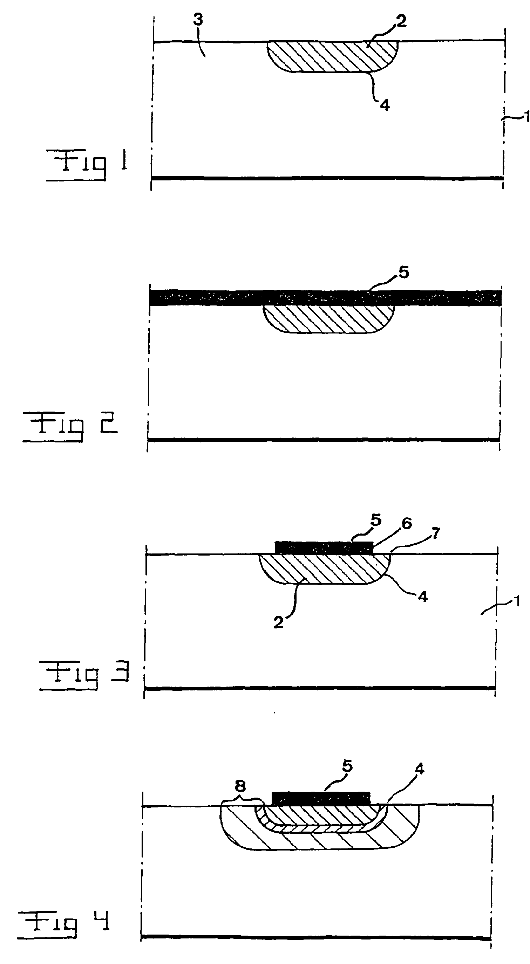

- Fig 1-4: illustrates very schematically the most important steps in a method for producing a semiconductor device according to a preferred embodiment of the invention.

### DETAILED DESCRIPTION OF A PREFERRED EMBODIMENT OF THE INVENTION

The method of which the most important steps are illustrated in Figs. 1-4, does of course also comprise several further steps of conventional type, such as masking, demasking, passivation and so on, but these have nothing to do with the inventional idea and have therefore been left out for the sake of clearness. Furthermore, the figures are very schematic and do not show for instance passivation layers or masking layers, which may be there. Furthermore, only the SiC layer into which it is implanted has been shown in the figures, but the semiconductor device created by this method will almost always have further layers thereunder or therebeside.

It is started with a SiC layer 1, which in this case is low doped with n-type impurity dopants for forming a drift layer of the device to be produced.

In a step a) the surface of the SiC semiconductor layer 1 is exposed to a bombardment of ions of p-type, such as for instance aluminium or boron. The energy used for the bombardment of said surface by the ions is preferably in the range of 100 KeV - 300 KeV. A thin surface layer 2 having a thickness in the region of tenth of µm with a concentration of dopants between 10¹⁵-10¹⁹ cm⁻³ is in this way created. These dopants are still not electrically active after this implantation step, and the SiC layer has to be heated to a temperature above 1500°C for obtaining such activation of the p-type dopants. It is evident that a suitable mask has been used, for instance of gold, for obtaining the lateral limitation of the surface layer 2 shown in Fig. 1. The layer 3 of the SiC layer 1 located thereunder will accordingly be n-type doped, so that a pn-junction 4 is formed at the interface between the two layers 2 and 3. Thus, a planar pn-junction is formed in this way.

In a second step a thin highly doped additional semiconductor layer 5 is epitaxially grown on top of the SiC layer 1, and this is accomplished by using the so called Chemical Vapour Deposition technique, during which the SiC layer 1 is heated at a temperature above 1500°C, through which the impurity dopants implanted in said surface layer 2 will be made electrically active. This high temperature is also needed for cracking the precursor gases used for the epitaxial growth of SiC of the layer 5. In this way a highly doped epitaxial layer of SiC may be grown. This layer may have a doping concentration above 10²⁰ cm⁻³ and more exactly a concentration of approximately 10²¹ cm⁻³ may be obtained, which is well more than one order of magnitude higher than may be obtained by the implantation technique. Preferably aluminium is used as impurity dopant grown into said additional semiconductor layer 5, but also other elements are conceivable.

After said step of epitaxial growth said additional semiconductor layer 5 is structured by for instance RIE, so that it receives the lateral extension shown in Fig 3 with lateral walls 6 thereof surrounded by the surface contour 7 of the surface layer 2 with a distance therebetween for separating the pn-junction 4 from the layer 5.

It is illustrated in Fig. 4 how the depletion region 8 created at both sides of said pn-junction 4 will not reach the contact layers 5 when the semiconductor device so created is reverse biased. Accordingly, no high electric field will occur at said lateral walls 6, and the area of the pn-interface, at which a high electric field is present, will be located entirely in the semiconductor material, so that the advantages of a high field strength material like SiC can be utilized.

The drift layer 3 of such a device will take the main part of the voltage in the blocking state of such a semiconductor device, and this has preferably also at least a highly doped substrate layer directly under the drift layer 3 or with other layers therebetween for forming a good ohmic contact at the opposite side of the device to said contact layer 5.

The invention is of course not in any way restricted to the preferred embodiment described above, but many possibilities to modifications thereof would be apparent to a man with ordinary skill in the art without departing from the basic idea of the invention.

It may for instance be mentioned that although the dopants in said surface layer and said contact layer are of the same conductivity type, it is well possible to have different dopants in these two layers.

When it is said that the semiconductor device has a semiconductor layer of SiC it does not necessarily mean that the semiconductor device has SiC as the only semiconductor material, but only the region in which the implantation takes place and in which a pn-junction is formed has to be of SiC and the device may have hetero-character should this be desired.

Furthermore, the pn-junction will in practise move a little bit into the semicondutor layer when this is heated during the step of epitaxial growth through diffusion of the implanted dopants, although this has not been illustrated in the figures.

The definition "layer" is to be interpreted broadly.

All definitions concerning the material of different layers of course also include inevitable impurities as well as intentional doping.

Although annealing is automatically obtained by the CVD regrowth step an additional annealing step may be carried out in combination with the regrowth. For instance, first an annealing step above 1700°C is carried out for 30 min and then is the temperature reduced to 1550-1620°C and the growth is performed.

## Claims

1. A method for producing a semiconductor device having a SiC layer (1) with a pn-junction therein, comprising a step a) of implanting an impurity dopant of a first conductivity type, one of a) n and b) p, into said SiC layer (1) being doped according to a second opposite conductivity type for forming a first type doped surface layer (2) surrounded, except for the top surface thereof, by second conductivity type doped regions (3) of said SiC layer for forming a pn-junction (4) at the interface thereto, **characterized by** a step b) following upon step a) and in which a highly doped additional semiconductor layer (5) of said first conductivity type is epitaxially grown on top of said surface layer for forming a contact layer allowing a low resistance ohmic contact to be established to the device so created.

2. A method according to claim 1, **characterized by** one of
a) in step b) said additional semiconductor layer (5) is grown on top of said surface layer (2) with lateral walls (6) thereof being surrounded by the surface contour (7) of said surface layer with a distance therebetween for separating the pn-junction (4) from said contact layer, and
b) in step b) said additional semiconductor layer (5) is grown on top of said SiC layer (1) and after that structured so that lateral walls (6) thereof are surrounded by the surface contour (7) of said surface layer with a distance therebetween for separating the pn-junction (4) from said contact layer.

3. A method according to claim 2, **characterized in that** said contact layer (5) is given a lower surface contour corresponding to a coverage of the main part of said surface layer (2).

4. A method according to claim 2 or 3, **characterized in that** said distance separating said pn-junction (4) from said contact layer (5) is selected so as to prevent the depletion region (8) of said junction under the intended reverse bias of the semiconductor device so created from reaching said contact layer.

5. A method according to any of claims 1-4, **characterized in that** said contact layer (5) is in step b) epitaxially grown with a doping concentration above 10¹⁹ cm⁻³.

6. A method according to any of claims 1-5, **characterized in that** said contact layer (5) is in step b) epitaxially grown with a doping concentration above 10²⁰ cm⁻³.

7. A method according to any of claims 1-6, **characterized in that** said contact layer (5) is in step b) grown by epitaxy of SiC and impurity dopants.

8. A method according to any of claims 1-7, **characterized in that** said first conductivity type dopants implanted in step a) and grown into the additional semiconductor layer (5) in step b) are of p-type.

9. A method according to claim 7, **characterized in that** Al is used as impurity dopant in said additional semiconductor layer (5).

10. A method according to any of claims 1-9, **characterized in that** said additional semiconductor layer (5) is grown by Chemical Vapour Deposition (CVD).

11. A method according to claim 10, **characterized in that** said additional semiconductor layer (5) is grown while heating said SiC layer (1) at such a high temperature that the impurity dopants implanted in step a) are made electrically active and implantation damages are reduced.

12. A method according to claims 7 and 11, **characterized in that** said temperature is higher than 1 500°C.

13. A method according to any of claims 1-11, **characterized in that** in step a) the implantation is carried out for obtaining a doping concentration in said surface layer (2) of 10¹⁵-10¹⁹ cm⁻³.

## Patentansprüche

1. Verfahren zum Herstellen einer Halbleitervorrichtung, die eine SiC-Schicht (1) mit einem pn-Übergang darin aufweist, umfassend einen Schritt a), dass ein Fremdstoffdotiermittel mit einem ersten Leitfähigkeitstyp von a) n oder b) p in die SiC-Schicht (1) implantiert wird, die gemäß einem zweiten entgegengesetzten Leitfähigkeitstyp dotiert wird, um eine mit einem ersten Typ dotierte Oberflächenschicht (2) zu bilden, die mit Ausnahme ihrer oberen Oberfläche von mit einem zweiten Leitfähigkeitstyp dotierten Bereichen (3) der SiC-Schicht umgeben ist, um einen pn-Übergang (4) an der Grenzfläche dazu zu bilden,
**gekennzeichnet durch**
einen Schritt b), der dem Schritt a) folgt und bei dem eine hoch dotierte zusätzliche Halbleiterschicht (5) mit dem ersten Leitfähigkeitstyp epitaktisch oben auf der Oberflächenschicht aufgewachsen wird, um eine Kontaktschicht zu bilden, die zulässt, dass ein ohmscher Kontakt mit niedrigem Widerstand zu der so geschaffenen Vorrichtung hergestellt wird.

2. Verfahren nach Anspruch 1,
**dadurch gekennzeichnet, dass**
a) in Schritt b) die zusätzliche Halbleiterschicht (5) oben auf der Oberflächenschicht (2) aufgewachsen wird, wobei Seitenwände (6) davon von der Oberflächenkontur (7) der Oberflächenschicht mit einem Abstand dazwischen zum Trennen des pn-Übergangs (4) von der Kontaktschicht umgeben sind, oder
b) in Schritt b) die zusätzliche Halbleiterschicht (5) oben auf der SiC-Schicht (1) aufgewachsen wird und danach derart strukturiert wird, dass Seitenwände (6) davon von der Oberflächenkontur (7) der Oberflächenschicht mit einem Abstand dazwischen zum Trennen des pn-Übergangs (4) von der Kontaktschicht umgeben sind.

3. Verfahren nach Anspruch 2,
**dadurch gekennzeichnet, dass**
der Kontaktschicht (5) eine niedrigere Oberflächenkontur entsprechend einer Abdeckung des Hauptteils der Oberflächenschicht (2) verliehen wird.

4. Verfahren nach Anspruch 2 oder 3,
**dadurch gekennzeichnet, dass**
der Abstand, der den pn-Übergang (4) von der Kontaktschicht (5) trennt, derart gewählt wird, dass verhindert wird, dass die Verarmungszone (8) des Übergangs unter der beabsichtigten Sperrspannung der so geschaffenen Halbleitervorrichtung die Kontaktschicht erreicht.

5. Verfahren nach einem der Ansprüche 1 bis 4,
**dadurch gekennzeichnet, dass**
die Kontaktschicht (5) in Schritt b) epitaktisch mit einer Dotierungskonzentration über 10¹⁹ cm⁻³ aufgewachsen wird.

6. Verfahren nach einem der Ansprüche 1 bis 5,
**dadurch gekennzeichnet, dass**
die Kontaktschicht (5) in Schritt b) epitaktisch mit einer Dotierungskonzentration über 10²⁰ cm⁻³ aufgewachsen wird.

7. Verfahren nach einem der Ansprüche 1 bis 6,
**dadurch gekennzeichnet, dass**
die Kontaktschicht (5) in Schritt b) durch Epitaxie von SiC und Fremdstoffdotiermitteln aufgewachsen wird.

8. Verfahren nach einem der Ansprüche 1 bis 7,
**dadurch gekennzeichnet, dass**
die Dotiermittel mit dem ersten Leitfähigkeitstyp, die in Schritt a) implantiert werden und in Schritt b) in die zusätzliche Halbleiterschicht (5) eingewachsen werden, vom p-Typ sind.

9. Verfahren nach Anspruch 7,
**dadurch gekennzeichnet, dass**
Al als Fremdstoffdotiermittel in der zusätzlichen Halbleiterschicht (5) verwendet wird.

10. Verfahren nach einen der Ansprüche 1 bis 9,
**dadurch gekennzeichnet, dass**
die zusätzliche Halbleiterschicht (5) durch chemische Abscheidung aus der Dampfphase (CVD) aufgewachsen wird.

11. Verfahren nach Anspruch 10,
**dadurch gekennzeichnet, dass**
die zusätzliche Halbleiterschicht (5) aufgewachsen wird, während die SiC-Schicht (1) auf solch eine hohe Temperatur erwärmt wird, dass die in Schritt a) implantierten Fremdstoffdotiermittel elektrisch aktiv gemacht und Implantationsschäden vermindert werden.

12. Verfahren nach den Ansprüchen 7 und 11,
**dadurch gekennzeichnet, dass**
die Temperatur höher als 1500°C ist.

13. Verfahren nach einem der Ansprüche 1 bis 11,
**dadurch gekennzeichnet, dass**
in Schritt a) die Implantation ausgeführt wird, um eine Dotierungskonzentration in der Oberflächenschicht (2) von 10¹⁵ - 10¹⁹ cm⁻³ zu erhalten.

## Revendications

1. Procédé de fabrication d'un dispositif à semi-conducteur ayant une couche de SiC (1) avec une jonction pn dans celle-ci, comprenant une étape a) d'implanter une impureté de dopage d'un premier type de conductivité, l'un de a) n et b) p, dans ladite couche de SiC (1) qui est dopée selon un second type de conductivité opposé pour former une couche superficielle dopée du premier type (2) entourée, à l'exception de la surface supérieure de celle-ci, par des régions dopées (3) du second type de conductivité de ladite couche de SiC pour former une jonction pn (4) au niveau de l'interface entre celles-ci,
**caractérisé par** une étape b) qui suit l'étape a) et dans laquelle une couche à semi-conducteur supplémentaire très dopée (5) dudit premier type de conductivité a crû de façon épitaxiale sur le dessus de ladite couche superficielle pour former une couche de contact permettant d'établir un contact à faible résistance ohmique vers le dispositif ainsi créé.

2. Procédé selon la revendication 1,
**caractérisé par** l'une de
a) dans l'étape b) ladite couche à semi-conducteur su-pplémentaire (5) a crû sur le dessus de ladite couche superficielle (2) avec des puits latéraux (6) de celle-ci qui sont entourés par le contour de surface (7) de ladite couche superficielle avec une distance entre eux pour séparer la jonction pn (4) de ladite couche de contact, et
b) dans l'étape b) ladite couche à semi-conducteur supplémentaire (5) a crû sur le dessus de ladite couche de SiC (1) et après cela est structurée de sorte que les- parois latérales (6) de celle-ci sont entourées par le contour de surface (7) de ladite couche superficielle avec une distance entre elles pour séparer la jonction pn (4) de ladite couche de contact.

3. Procédé selon la revendication 2,
**caractérisé en ce que** ladite couche de contact (5) est donnée avec un contour de surface inférieur correspondant à une couverture de la partie principale de ladite couche superficielle (2).

4. Procédé selon la revendication 2 ou 3,
**caractérisé en ce que** ladite distance séparant ladite jonction pn (4) de ladite couche de contact (5) est choisie de façon à empêcher la région d'appauvrissement (8) de ladite jonction sous la polarisation inverse souhaitée du dispositif à semi-conducteur ainsi créé, d'atteindre ladite couche de contact.

5. Procédé selon une quelconque des revendications 1-4,
**caractérisé en ce que** ladite couche de contact (5) a, dans l'étape b), crû de façon épitaxiale avec une concentration de dopage au-dessus de 10¹⁹ cm⁻³.

6. Procédé selon une quelconque des revendications 1-5,
**caractérisé en ce que** ladite couche de contact (5) a, dans l'étape b), crû de façon épitaxiale avec une concentration de dopage au-dessus de 10²⁰ cm⁻³.

7. Procédé selon une quelconque des revendications 1-6,
**caractérisé en ce que** ladite couche de contact (5) a, dans l'étape b), crû par épitaxie d'impuretés de dopage et de SiC.

8. Procédé selon une quelconque des revendications 1-7,
**caractérisé en ce que** lesdits dopants du premier type de conductivité implantés dans l'étape a) et qui ont crû dans la couche à semi-conducteur supplémentaire (5) dans l'étape b) sont du type p.

9. Procédé selon la revendication 7,
**caractérisé en ce que** Al est utilisé en tant qu'impureté de dopage dans ladite couche à semi-conducteur supplémentaire (5).

10. Procédé selon une quelconque des revendications 1-9,
**caractérisé en ce que** ladite couche à semi-conducteur supplémentaire (5) a crû par dépôt chimique en phase vapeur (CVD).

11. Procédé selon la revendication 10,
**caractérisé en ce que** ladite couche à semi-conducteur supplémentaire (5) a crû tout en chauffant ladite couche de SiC (1) à une température élevée de telle sorte que les impuretés de dopage implantées dans l'étape a) soient rendues électriquement actives et que les dommages d'implantation soient réduits.

12. Procédé selon la revendication 7 et 11,
**caractérisé en ce que** ladite température est supérieure à 1500°C.

13. Procédé selon une quelconque des revendications 1-11,
**caractérisé en ce que**, dans l'étape a), l'implantation est mise en oeuvre pour obtenir une concentration de dopage dans ladite couche superficielle (2) de 10¹⁵-10¹⁹ cm⁻³.
